Europäisches Patentamt

European Patent Office

Office européen des brevets

(11) Veröffentlichungsnummer: **0 182 033**
**A2**

# (12) EUROPÄISCHE PATENTANMELDUNG

(21) Anmeldenummer: 85111822.4

(22) Anmeldetag: 18.09.85

(51) Int. Cl.⁴: **H01S 3/08** , G02B 6/16 ,
G02B 6/26 , G02B 6/42

(30) Priorität: 25.09.84 DE 3435172

(43) Veröffentlichungstag der Anmeldung:
28.05.86 Patentblatt 86/22

(84) Benannte Vertragsstaaten:
DE FR GB

(71) Anmelder: **Siemens Aktiengesellschaft**
**Berlin und München Wittelsbacherplatz 2**
**D-8000 München 2(DE)**

(72) Erfinder: **Auracher, Franz, Dr. Dipl.-Ing.**
**Eichenstrasse 26**
**D-8021 Baierbrunn(DE)**
Erfinder: **Schneider, Hartmut, Dr. Dipl.-Chem.**
**Blütenstrasse 12**
**D-8000 München 40(DE)**
Erfinder: **Böck, Georg, Dr. Dipl.-Ing.**
**Am Pichelssee 2**
**D-1000 Berlin 20(DE)**

(54) **Schmalbandiger Lasersender.**

(57) Es wird ein schmalbandiger Lasersender aus einem Halbleiterlaser und aus einem daran angekoppelten externen optischen Resonator zur Erzeugung sehr schmaler Linienbreiten beschrieben, bei dem zur Schaffung eines für den praktischen Einsatz geeigneten, raumsparenden und insbesondere stabilen schmalbandigen Lasersenders der externe optische Resonator aus einem wellenlängenselektiven Faserrichtkoppler in Form einer Doppelkernfaser besteht, deren Kerne unterschiedliche Brechzahlsprünge zu ihrer jeweiligen Umgebung und unterschiedliche Querschnitte haben. Weitere bevorzugte und vorteilhafte Ausgestaltungen des schmalbandigen Lasersenders werden beschrieben.

## FIG 1

## Schmalbandiger Lasersender

Die Erfindung betrifft einen schmalbandigen Lasersender nach dem Oberbegriff des Patentanspruchs 1, insbesondere einen Lasersender mit einem Halbleiterlaser.

Bei optischen Übertragungssystemen mit Heterodyn- oder Heterodynempfängern werden einmodige Lasersender benötigt, die eine sehr schmale Linienbreite haben. In Laborexperimenten wird dies derzeit mit üblichen Halbleiterlasern erreicht, die durch Kopplung an externe optische Resonatoren, Gitter oder Fabry-Perot-Filter in ihren spektralen Eigenschaften verbessert werden. Ein typischer derartiger Aufbau mit einem externen Gitter zur Grobeinstellung der Laserwellenlänge und einem Fabry-Perot-Etalon zur Feinabstimmung geht aus R.Wyatt und W.J. Devlin: 10 kHz Line width 1.5 μm InGaAsP External Cavitiy Laser with 55 nm Tuning Range, Electr. Lett. 19 (1983) S. 110-112 hervor. Dieser Aufbau mit freier Strahlausbreitung ist für praktische Systeme ungeeignet, da der Aufwand zu hoch ist und vor allem die thermische und mechanische Stabilität nicht ausreicht.

Ein kompakterer Aufbau mit einem externen Faserresonator ist in F.Favre, D. Le Guen: Emission Frequency Stability in Single-Mode-Fibre Optical Feedback Controlled Semiconductor Lasers, Electr. Lett. 19 (1983) S. 663-665 beschrieben. Bei diesem Aufbau werden jedoch die eng benachbarten Resonanzen des externen Resonators durch kein schmalbandiges Filter selektiert, so daß der Lasersender dazu neigt, zwischen benachbarten Resonanzfrequenzen zu springen.

Gemeinsam ist Aufbauten mit freier Strahlausbreitung, daß sie voluminös, teuer und nicht stabil sind, und daher für einen praktischen Einsatz nicht in Frage kommen.

Aufgabe der vorliegenden Erfindung ist es, einen für den praktischen Einsatz geeigneten, raumsparenden und insbesondere stabilen schmalbandigen Lasersender der eingangs genannten Art zu schaffen.

Diese Aufgabe wird gemäß dem kennzeichnenden Teil des Patentanspruchs 1 dadurch gelöst, daß der externe optische Resonator aus einem wellenlängenselektiven optischen Richtkoppler besteht.

Bei dem erfindungsgemäßen Lasersender ist die freie Strahlausbreitung zugunsten einer geführten Strahlausbreitung im Richtkoppler aufgegeben, in dem eine stabile Strahlausbreitung ermöglicht ist. Außerdem ist der Aufbau eines optischen Richtkopplers kompakt und raumsparend, so daß auch der damit aufgebaute Lasersender entsprechend ausgebildet ist.

Eine besonders bevorzugte Ausführungsform des erfindungsgemäßen Senders ist nach Anspruch 2 so ausgebildet, daß der wellenlängenselektive optische Richtkoppler aus einem wellenlängenselektiven Faserrichtkoppler besteht.

Faserrichtkoppler können besonders kompakt und damit raumsparend in Form von Doppelkernfasern hergestellt werden. Demgemäß ist es von Vorteil, eine derartige Doppelkernfaser auch für den erfindungsgemäßen Sender nach Anspruch 2 zu verwenden. Ein derartiger Sender ist erfindungsgemäß nach Anspruch 3 so ausgestaltet, daß der wellenlängenselektive Faserrichtkoppler aus einer Doppelkernfaser besteht, deren Kerne unterschiedliche Brechzahlsprünge zu ihrer jeweiligen Umgebung und unterschiedliche Querschnitte haben. Beispiele für eine derartige wellenlängenselektive Doppelkernfaser und Herstellungsverfahren dafür werden angegeben.

Besonders vorteilhaft ist es, wenn bei einem erfindungsgemäßen Lasersender die Wellenleiter des wellenlängenselektiven optischen Richtkopplers polarisationserhaltend ausgeführt sind (Anspruch 4). Dies kann beispielsweise mittels Formdoppelbrechung, z.B. durch elliptische Kerne im Faserrichtkoppler, oder durch Spannungsdoppelbrechung (siehe D.N. Paye, A.J. Barlow, J.J.R. Hansen: Development of Low- and High-Birefringence Optical Fibers, IEEE J. Ouant. Electr., QE-18 (1982) S. 477-487) erreicht werden.

Für die Erzielung sehr schmaler Linienbreiten ist es besonders vorteilhaft, einen erfindungsgemäßen Sender gemäß Anspruch 5 so zu gestalten, daß der wellenlängenselektive optische Richtkoppler so ausgebildet ist, daß dessen Wellenleiter unterschiedlich steil verlaufende Dispersionskurven aufweisen, die sich bei einer vom Laser emittierten Wellenlänge schneiden. Derartige Dispersionskurven, welche die Abhängigkeit der Ausbreitungskonstante β von der Wellenlänge λ angeben, erhält man z.B. bei richtiger Wahl der Brechzahlprofile und der Kernquerschnitte im Faserrichtkoppler. Bei der bestimmten Wellenlänge, bei der sich die unterschiedlich steil verlaufenden Dispersionskurven schneiden, ist dann - bei richtig dimensionierter Länge des Richtkopplers - eine vollständige Überkopplung von einem Wellenleiter auf den anderen möglich, während bei anderen Wellenlängen nur noch eine teilweise Überkopplung erfolgt.

Für manche Anwendungsfälle, beispielsweise bei der Verwendung dieser wellenlängenselektiven Richtkoppler für optische Wellenlängenmultiplex-Übertragung, sind die teilweisen Überkopplungen bei anderen Wellenlängen unerwünscht. Zur Unterdrückung dieser teilweisen Überkopplungen ist es zweckmäßig, einen erfindungsgemäßen Sender so zu gestalten, daß gemäß Anspruch 6 die Koppelstärke entlang der Koppelstrecke des wellenlängenselektiven optischen Richtkopplers variiert. Richtkoppler mit variierender Koppelstärke entlang der Koppelstrecke sind aus R.C. Alfernesse: Optical directional couplers with weighted coupling, Appl. Phys. Lett. 35 (1979) S. 260-262 bekannt.

Eine bevorzugte Ausführungsform eines erfindungsgemäßen Senders, insbesondere eines Senders nach Anspruch 5 oder 6 ist gemäß Anspruch 7 so ausgestaltet, daß ein Wellenleiter des wellenlängenselektiven optischen Richtkopplers an den Laser angekoppelt, und der andere Wellenleiter an dem vom Laser fernen Ende des Richtkopplers verspiegelt ist. Die Emission des Lasers in der Nähe der bestimmten Wellenlänge, bei der sich die Dispersionskurven schneiden, wird dann wieder in die Laserquelle zurückreflektiert, während sie bei anderen Wellenlängen in einem optischen Sumpf am fernen Ende des Richtkopplers absorbiert werden kann.

Die Ankopplung des Richtkopplers in dem Sender nach Anspruch 7 kann auf unterschiedliche Art erfolgen. Gemäß Anspruch 8 dadurch, daß der Laser über eine Gradientenlinse an den einen Wellenleiter des wellenlängenselektiven optischen Richtkopplers gekoppelt ist, oder gemäß Anspruch 9 dadurch, daß der Laser über einen Fasertaper mit angeschmolzener Linse an den einen Wellenleiter des wellenlängenselektiven optischen Richtkopplers gekoppelt ist.

Im allgemeinen ist es bei einem erfindungsgemäßen Sender nach einem der Ansprüche 7 bis 9 vorteilhaft, wenn gemäß Anspruch 10 die Lichtaustrittsfläche des Lasers und die Lichteintrittsfläche einer Koppeloptik zum Ankoppeln des Lasers an den einen Wellenleiter des wellenlängenselektiven optischen Richtkopplers entspiegelt wird.

Die Erfindung wird anhand der Figuren in der folgenden Beschreibung näher erläutert. Von den Figuren zeigen:

Figur 1 schematisch den typischen Aufbau des aus Electr. Lett. 19 (1983) S. 110-112 bekannten Lasersenders;

Figur 2 in schematischer Darstellung einen Lasersender mit einem externen Resonator in Form eines wellenlängenselektiven optischen Richtkopplers;

Figuren 3 und 4 in schematischer Darstellung jeweils einen Lasersender mit wellenlängenselektivem optischem Richtkoppler als externem Resonator, wobei verschiedene Möglichkeiten der Ankopplung des Lasers an den Richtkoppler gezeigt sind;

Figuren 5a bis 5b Querschnitte durch drei verschiedene Ausführungsformen von wellenlängenselektiven Faserrichtkopplern in Form von Doppelkernfasern und darunter jeweils schematisch das radiale Brechzahlprofil in der Doppelkernfaser;

Figur 6 in einem Diagramm verschieden steil verlaufende und sich schneidende Dispersionskurven; und

Figur 7 in einem Diagramm den typischen Verlauf der Überkopplung in einem Richtkoppler mit den Eigenschaften der Figur 6 über der Wellenlänge.

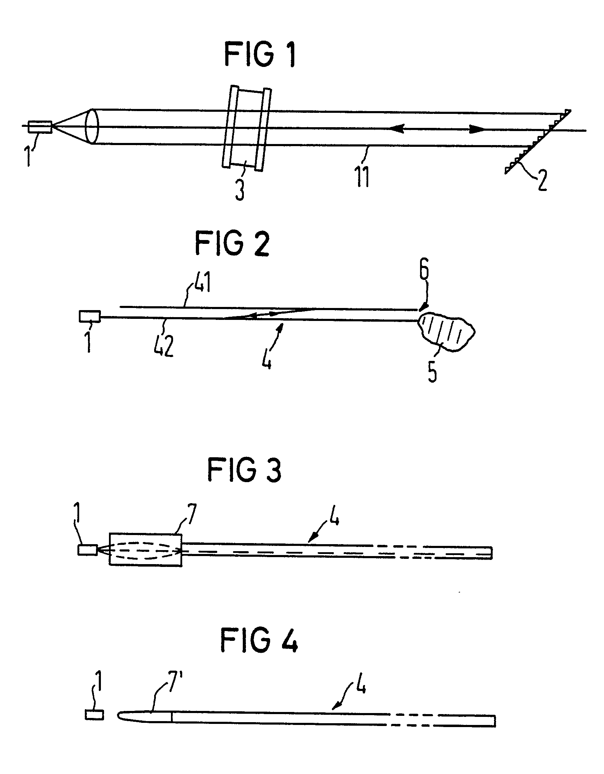

In dem bekannten Lasersender nach Figur 1 sind im Strahlengang 11 des von der Laserdiode 1 abgestrahlten Laserlichts das zur Grobeinstellung dienende geblazte Gitter 2 und zwischen diesem Gitter 2 und der Laserdiode 1 das zur Feinabstimmung dienende Fabry-Perot-Etalon 3 angeordnet. Die Figur 1 dient nur dazu, eine Vorstellung zu vermitteln, wie ein herkömmlicher Lasersender aufgebaut ist.

Dagegen besteht der Lasersender nach Figur 2 aus der Laserdiode 1 und dem daran angekoppelten wellenlängenselektiven optischen Richtkoppler 4 mit zwei optischen Wellenleitern 41 und 42, längs denen die wellenlängenselektive Überkopplung erfolgt. Die Laserdiode 1 ist an den einen Wellenleiter 42 angekoppelt, der an dem von der Laserdiode 1 fernen Ende in einen optischen Sumpf 5 mündet. Der andere Wellenleiter 41 ist an seinem von der Laserdiode 1 fernen Ende durch einen Spiegel 6 abgeschlossen, der das zugeführte Licht in den Wellenleiter 41 zurückreflektiert.

Die Überkopplung zwischen den Wellenleitern 41 und 42 erfolgt im wesentlichen nur in der Nähe einer bestimmten Wellenlänge $\lambda_0$. Wird die diese bestimmte Wellenlänge $\lambda_0$ enthaltende Laseremission in den Richtkoppler 4 eingekoppelt, dann gelangt im wesentlichen nur die Laseremission in der Nähe der bestimmten Wellenlänge $\lambda_0$zum Spiegel 6, von wo sie wieder in die Laserdiode zurückreflektiert wird. Die Laseremission bei anderen Wellenlängen wird in dem optischen Sumpf 5 absorbiert.

Bei der Ausführungsform nach Figur 3 des Lasersenders nach Art der Figur 2 erfolgt die Ankopplung des Lasers 1 an den wellenlängenselektiven Richtkoppler 4 durch eine Gradientenlinse 7, die beispielsweise auch ein Stück Multimode-Gradientenfaser geeigneter Länge sein kann. Sie kann beispielsweise mit dem wellenlängenselektiven optischen Richtkoppler, insbesondere in Form eines Faserrichtkopplers, fest verkittet oder verschweißt sein.

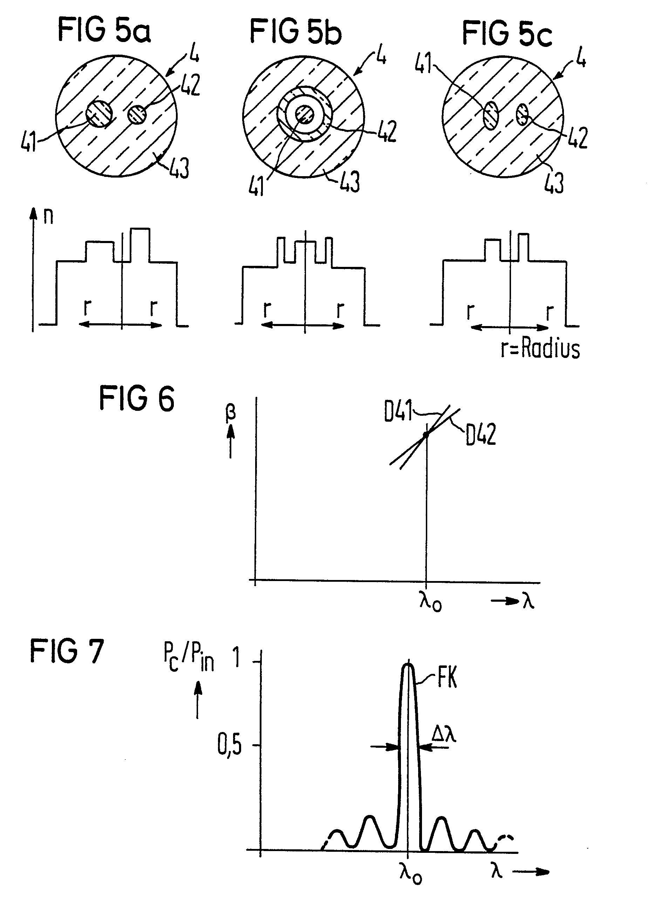

Bei der Ausführungsform nach Figur 4 erfolgt die Ankopplung des Lasers 1 an den wellenlängenselektiven optischen Richtkoppler 4 anstelle mit einer Gradientenlinse mit einem Fasertaper 7' mit angeschmolzener Linse, der beispielsweise ein Stück einer getaperten Monomodefaser mit angeschmolzener Linse sein kann. Bei einem Faserrichtkoppler mit rotationssymmetrischem Aufbau, beispielsweise in Form der später beschriebenen und aus der Figur 5b hervorgehenden Doppelkernfaser, kann der Richtkoppler selbst taperförmig ausgezogen oder abgeätzt und an ihn eine kleine Linse angeschmolzen werden. Im allgemeinen ist es vorteilhaft, wenn der Austrittsspiegel des Lasers und die Eintrittsfläche der Koppeloptik zum Ankoppeln des Lasers an den Richtkoppler entspiegelt werden.

Der wellenlängenselektive optische Richtkoppler 4 kann durch einen wellenlängenselektiven Faserrichtkoppler realisiert sein. Vorteilhaft ist es dabei, ihn durch eine Doppelkernfaser zu realisieren, wobei der Abstand zwischen den Faserkernen, welche die Wellenleiter 41 und 42 repräsentieren, so gewählt wird, daß eine Kopplung zwischen den beiden Wellenleitern der Doppelkernfaser auftritt.

Die beiden Kerne der Doppelkernfaser haben unterschiedliche Brechzahlsprünge zu ihrer jeweiligen Umgebung und unterschiedliche Querschnitte. Die Brechzahlsprünge können durch unterschiedliche Dotierungen, beispielsweise unterschiedliche Dotierstoffkonzentrationen oder unterschiedliche Dotierstoffe, erzeugt werden. Beispiele für derartige geeignete Doppelkernfaser zeigen die Figuren 5a bis 5c im Querschnitt.

Die Doppelkernfaser 4 nach Figur 5a weist zwei von einem gemeinsamen Mantel 43 umgebene und im Querschnitt kreisförmige Kerne 41, 42 unterschiedlichen Durchmessers auf. Der Durchmesser des Kerns 41 ist beispielsweise größer als der Durchmesser des Kerns 42. Dafür hat der Kern 42 einen größeren Brechzahlsprung zum umgebenden Mantel der Kern 41, wie dies deutlich aus den darunter dargestellten Verlauf des radialen Brechzahlprofils der Faser 4 hervorgeht.

Die Doppelkernfaser 4 nach Figur 5b weist rotationssymmetrischen Aufbau auf. Der zentrale Kern 41 ist von einem im Querschnitt ringförmigen Kern 42 mit Abstand umgeben, den wiederum der Mantel 43 umgibt.

Das radiale Brechzahlprofil der Faser 4 zeigt wieder deutlich, daß die beiden Kerne 41 und 42 verschiedene Brechzahlsprünge zu ihrer jeweiligen Umgebung aufweisen. Ein Richtkoppler nach Figur 5b ist beispielsweise in J.R. Cozens, A.C. Boucouvalas und N.L. Webster: Co-Axial Optical Couplers, IEE 1st Europ. Conf. on Integrated Optics, 14.-15.Sept. 1981, Conf. Publications Nr. 201, S. 102-106 beschrieben.

Die Doppelkernfaser 4 nach Figur 5c ist wie die Faser 4 nach Figur 5a aufgebaut, mit dem einzigen Unterschied, daß bei der Faser 4 nach Figur 5c die Kerne 41 und 42 ovalen oder elliptischen Querschnitt aufweisen.

Die Richtkoppler nach den Figuren 5a bis 5c lassen sich durch Dünnziehen aus entsprechenden Vorformen gewinnen, die beispielsweise nach dem MCVD-Verfahren (siehe dazu H. Schneider, G. Zeidler: Herstellverfahren und Ausführungsformen von Lichtwellenleitern, telcom report 6 (1983) Beiheft "Nachrichtenübertragung mit Licht", S.29-35) hergestellt werden können. Für die Präparation der Strukturen nach den Figuren 5a und 5c werden zweckmäßigerweise zwei einkernige Vorformen verwendet, die dann nach einseitigem Abschleifen zur Doppelkernvorform verschweißt werden (siehe dazu G. Schiffner, H. Schneider, G. Schöner: Double-Core Single-Mode Optical Fiber as Directional Coupler, Appl. Phys. 23 (1980) S. 41-45). Zur Herstellung des konzentrischen Fasertyps nach Figur 5b genügt eine Vorform, deren Brechzahlprofil in prinzipiell bekannter Weise durch Variation der Dotiergaskonzentration bei der Abscheidung aus der Gasphase hergestellt wird. Besonders für diesen Fasertyp kann eine hohe Maßhaltigkeit bei der Fertigung erwartet werden.

Besonders vorteilhaft ist es, wenn die Wellenleiter des Richtkopplers polarisationserhaltend ausgeführt werden. Dies kann beispielsweise mittels Formdoppelbrechung durch elliptische Form der Kerne, wie sie etwa bei der Doppelkernfaser nach Figur 5c gegeben sind oder, wie bekannt, durch Spannungsdoppelbrechung erreicht werden. Bei richtiger Wahl der Brechzahlprofile und der Kernquerschnitte erhält man dann Dispersionskurven D41, D42, die für die beiden Wellenleiter unterschiedlich steil verlaufen und die sich bei einer bestimmten Wellenlänge $\lambda_0$ schneiden, wie dies aus dem Diagramm nach Figur 6 hervorgeht, bei dem auf der Abszisse die Wellenlänge und auf der Ordinate die Ausbreitungskonstante $\beta$ aufgetragen ist. Bei der bestimmten Wellenlänge $\lambda_0$ ist dann - bei richtig dimensionierter Länge des Richtkopplers - eine vollständige Überkopplung von einem Wellenleiter auf den anderen möglich, während bei anderen Wellenlängen nur noch eine teilweise Überkopplung erfolgt. Ein typischer Verlauf der Überkopplung in Abhängigkeit von der Wellenlänge ist in dem Diagramm nach Figur 7 durch die Kurve FK gezeigt, bei dem auf der Abszisse die Wellenlänge und auf der Ordinate das Verhältnis zwischen überkoppelnder Leistung $P_c$ zu eingekoppelter Leistung $P_{in}$ aufgetragen ist.

Für manche Anwendungsfälle - beispielsweise bei Verwendung dieser wellenlängenselektiven optischen Richtkoppler für optische Wellenlängenmultiplexübertragung - sind die im Diagramm nach Figur 7 ersichtlichen Nebenmaxima in der Transmissionskurve FK unerwünscht. Um diese Nebenmaxima zu unterdrücken, muß die Koppelstärke entlang der Koppelstrecke des Richtkopplers variiert werden (siehe dazu R.C. Alferness: Optical directional couplers with weighted coupling, Appl. Phys. Lett. 35 (1979) S. 260-262). Dies kann entweder schon bei der Herstellung der Vorform, beispielsweise durch Schleifen eines geeigneten Profils der beiden einkernigen Vorformen, durch Variation der Abscheideparameter entlang der Vorformachse beim MCVD-Verfahren oder im Faserrichtkoppler selbst durch eine Nachbehandlung, beispielsweise durch einen Ionenaustauschprozeß erfolgen.

Der Breite der Transmissions- bzw. Filterkurve FK nach Figur 7 nimmt mit zunehmender Länge des Richtkopplers und mit zunehmend unterschiedlichen Steigungen der Dispersionskurven D41, D42 nach Figur 6 ab. Wird nun, wie im Zusammenhang mit der Figur 2 beschrieben, ein Wellenleiter des Richtkopplers an den Laser angekoppelt und der andere Wellenleiter am Ende des Richtkopplers verspiegelt, dann wird die Laseremission in der Nähe der bestimmten Wellenlänge $\lambda_0$ wieder in den Laser zurückreflektiert, während sie bei anderen Wellenlängen in einen optischen Sumpf am Ende des Richtkopplers absorbiert wird.

**Ansprüche**

1. Schmalbandiger Lasersender aus einem Laser, insbesondere einem Halbleiterlaser, und aus einem daran angekoppelten externen optischen Resonator zur Erzeugung sehr schmaler Linienbreiten, **dadurch gekennzeichnet,** daß der externe optische Resonator aus einem wellenlängenselektiven optischen Richtkoppler (4) besteht.

2. Sender nach Anspruch 1, **dadurch gekennzeichnet,** daß der wellenlängenselektive optische Richtkoppler (4) aus einem wellenlängenselektiven Faserrichtkoppler besteht.

3. Sender nach Anspruch 2, **dadurch gekennzeichnet,** daß der wellenlängenselektive Faserrichtkoppler (4) aus einer Doppelkernfaser besteht, deren Kerne (41, 42) unterschiedliche Brechzahlsprünge zu ihrer jeweiligen Umgebung und unterschiedliche Querschnitte haben.

4. Sender nach Anspruch 2 oder 3, **dadurch gekennzeichnet,** daß der Faserrichtkoppler (4) einen rotationssymmetrischen Aufbau zeigt.

5. Sender nach einem der vorhergehenden Ansprüche, **dadurch gekennzeichnet,** daß die Wellenleiter (41, 42) des wellenlängenselektiven optischen Richtkopplers (4) polarisationserhaltend ausgeführt sind.

6. Sender nach einem der vorhergehenden Ansprüche, **dadurch gekennzeichnet,** daß der wellenlängenselektive optische Richtkoppler (4) so ausgebildet ist, daß dessen Wellenleiter (41, 42) unterschied lich steil verlaufende Dispersionskurven (D41, D42) aufweisen, die sich bei einer bestimmten vom Laser (1) emittierten Wellenlänge ($\lambda_0$) schneiden.

7. Sender nach einem der vorhergehenden Ansprüche, insbesondere nach Anspruch 5, **dadurch gekennzeichnet,** daß die Koppelstärke entlang der Koppelstrecke des wellenlängenselektiven optischen Richtkopplers (4) variiert.

8. Sender nach einem der vorhergehenden Ansprüche, insbesondere nach Anspruch 5 oder 6, **dadurch gekennzeichnet,** daß ein Wellenleiter des wellenlängenselektiven optischen Richtkopplers (42) an den Laser (1) angekoppelt und der andere Wellenleiter (41) an dem vom Laser (1) fernen Ende des Richtkopplers (4) verspiegelt ist.

9. Sender nach Anspruch 8, **dadurch gekennzeichnet,** daß der Laser (1) über eine Gradientenlinse (7) an den einen Wellenleiter (42) des wellenlängenselektiven optischen Richtkopplers (4) gekoppelt ist.

10. Sender nach Anspruch 8, **dadurch gekennzeichnet,** daß der Laser (1) über einen Fasertaper (7') mit angeschmolzener Linse an den einen Wellenleiter (42) des wellenlängenselektiven optischen Richtkopplers (4) gekoppelt ist.

11. Sender nach einem der Ansprüche 8 bis 10, **dadurch gekennzeichnet,** daß die Lichtaustrittsfläche des Lasers (1) und die Lichteintrittsfläche einer Koppeloptik (7, 7') zum Ankoppeln des Lasers (1) an den einen Wellenleiter (42) des wellenlängenselektiven optischen Richtkopplers (4) entspiegelt sind.

# FIG 1

# FIG 2

# FIG 3

# FIG 4

# FIG 5a

# FIG 5b

# FIG 5c

r=Radius

# FIG 6

# FIG 7